Europäisches Patentamt

European Patent Office

Office européen des brevets

(19)

(11) Veröffentlichungsnummer : **0 080 014**
**B1**

(12) # EUROPÄISCHE PATENTSCHRIFT

(45) Veröffentlichungstag der Patentschrift :
30.12.86

(51) Int. Cl.⁴ : **H 03 D   3/00**

(21) Anmeldenummer : **82105412.9**

(22) Anmeldetag : **21.06.82**

(54) **Digitaler Demodulator frequenzmodulierter Signale.**

(30) Priorität : **26.09.81 DE 3138464**
**12.12.81 DE 3149318**

(43) Veröffentlichungstag der Anmeldung :
**01.06.83 Patentblatt 83/22**

(45) Bekanntmachung des Hinweises auf die Patenterteilung : **30.12.86 Patentblatt 86/52**

(84) Benannte Vertragsstaaten :
**DE FR GB IT SE**

(56) Entgegenhaltungen :
**EP-A- 0 035 166**
**FR-A- 2 219 570**
**H.W. SCHÜSSLER: "Digitale Systeme zur Signalverarbeitung", 1973, Seiten 75-128, Springer-Verlag, Berlin, DE.**

(73) Patentinhaber : **ROBERT BOSCH GMBH**
**Postfach 50**
**D-7000 Stuttgart 1 (DE)**

(72) Erfinder : **Kammeyer, Karl-Dirk, Dr.-Ing.**
**Lange Trift 13a**
**D-4790 Paderborn-Dahl (DE)**

EP 0 080 014 B1

## Beschreibung

Stand der Technik

Die Erfindung geht aus von einem digitalen Demodulator nach dem Oberbegriff des Hauptanspruchs. Aus der DE-OS 30 07 907 (EP-A-35 166) ist bereits ein digitaler Empfänger bekannt geworden, der einen digitalen Demodulator aufweist. Das digitale Signale wird dort zwei parallel arbeitenden Multiplizierern zugeführt, denen jeweils ein parallel arbeitendes ZF-Filter nachgeschaltet ist. Nach diesem Filter, das aus einem transversalen und einem rekursiven Filter besteht, wird die Abtastrate reduziert. Der Aufbau des Demodulators ist in dieser Schrift jedoch nicht angegeben.

Vorteile der Erfindung

Der erfindungsgemäße Demodulator für frequenzmodulierte Signale mit den kennzeichnenden Merkmalen des Hauptanspruchs hat demgegenüber den Vorteil, daß er mit bekannten digitalen Bauelementen aufbaubar ist. Die digitale Signalverarbeitung hat weiterhin den Vorteil, daß das Ergebnis absolut reproduzierbar ist und Temperatur- und Alterungsabhängigkeiten nicht auftreten. Abgleichprobleme entfallen. Weiterhin ist es vorteilhaft, daß solche Schaltungsanordnungen integrierbar auszuführen sind. Dies ist insbesondere dadurch ermöglicht, daß Spulen und große Kapazitäten keine Verwendung finden. Weitere Vorteile sind die beliebige Genauigkeit der Auflösung der Signale sowie die Möglichkeit der Steuerung der Zwischenfrequenzbandbreite in Abhängigkeit von der Empfangsqualität, da dies auf einfache Art und Weise durch digitale Signale oder Worte geschehen kann.

Durch die in den Unteransprüchen aufgeführten Maßnahmen sind vorteilhafte Weiterbildungen und Verbesserungen des im Hauptanspruch angegebenen Demodulators möglich. Besonders vorteilhaft ist, daß die Hilbert-Transformation näherungsweise durch versetzte Abtastung mit anschließender Interpolation erfolgt. Durch diese Maßnahme ergibt sich ein besonders einfacher Aufbau des Demodulators. Weiterhin ist es vorteilhaft, daß nach den nichtrekursiven Filtern eine Amplitudenregelung vorgesehen ist. Durch diese Maßnahme wird die korrekte Funktion des Demodulators bei hohen Frequenzhüben verbessert.

In einer weiteren Ausbildung der Erfindung wird das frequenzmodulierte Signal in digitaler Form jeweils mit einer Sinus- und einer Cosinusfunktion multipliziert. Durch diese Art der Signalaufbereitung erhält man nach den nichtrekursiven Filtern zueinander Hilbert-transformierte Signale, ohne daß es einer Interpolationsschaltung bedarf. Durch diese Filter werden durch die Multiplikation bedingte Anteile mit doppelter Zwischenfrequenz unterdrückt. Zur Verbesserung der Arbeitsweise des Demodulators ist es vorteilhaft, jeweils weitere digitale, nichtrekursive Filter vorzusehen. Dadurch läßt sich nach jedem Filter die Abtastrate des digitalen Signals verringern, so daß preisgünstigere Bauelemente Verwendung finden können.

Die nichtrekursiven Filter sind vorteilhafter Weise aus Schieberegistern oder RAMs als Zustandsspeicher aufgebaut, wobei die die Eigenschaften des Filters bestimmenden Koeffizienten in Speichergliedern abgelegt sind.

Weitere Vorteile ergeben sich aus der nachfolgenden Beschreibung in Verbindung mit den Zeichnungen.

Zeichnung

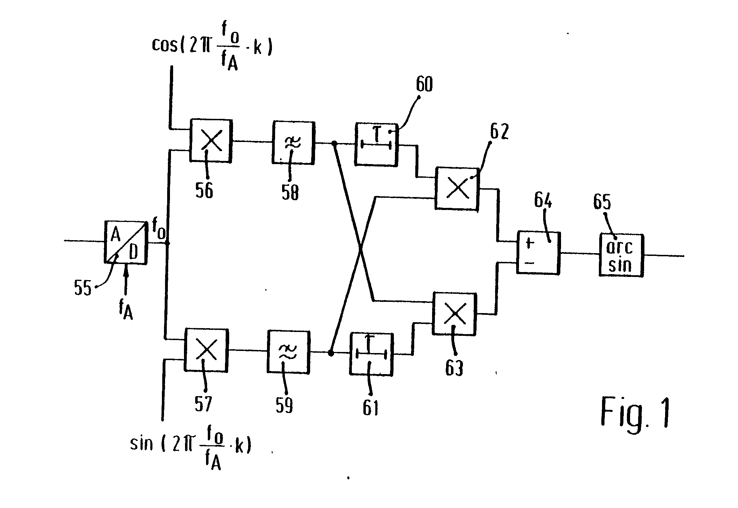

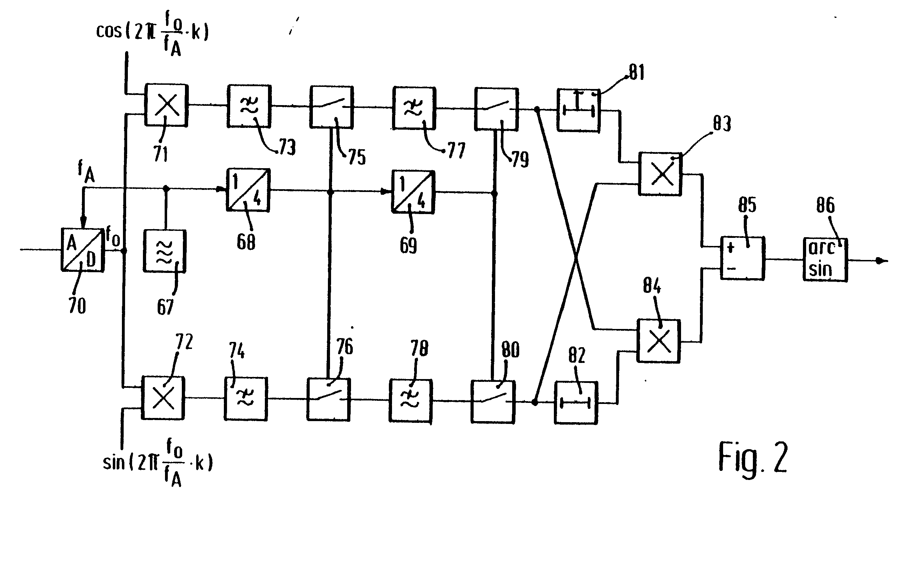

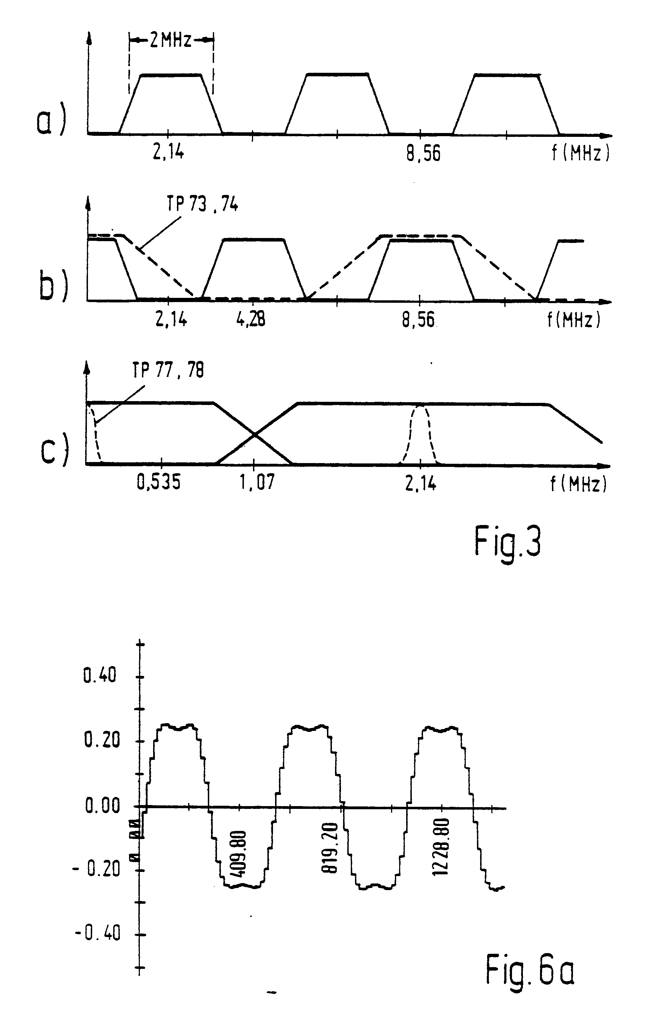

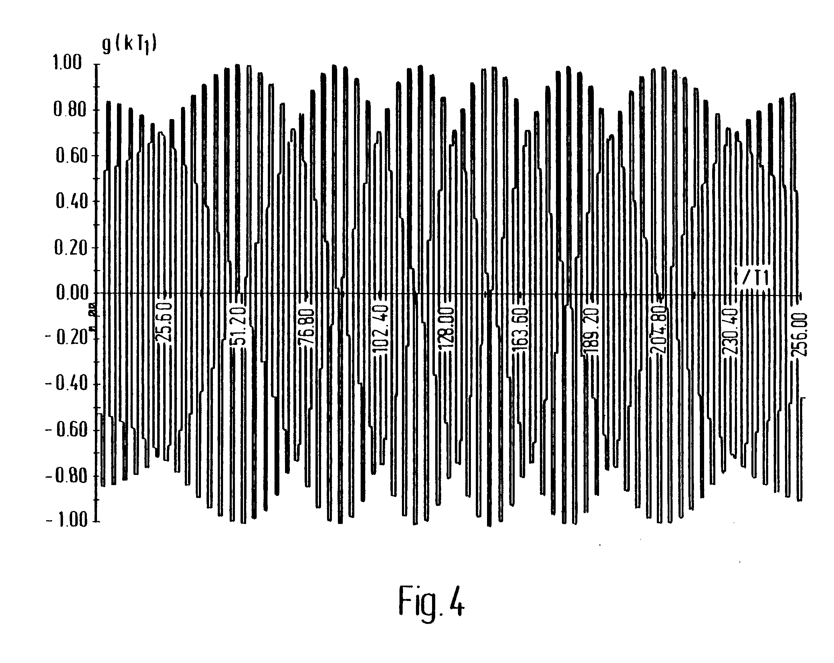

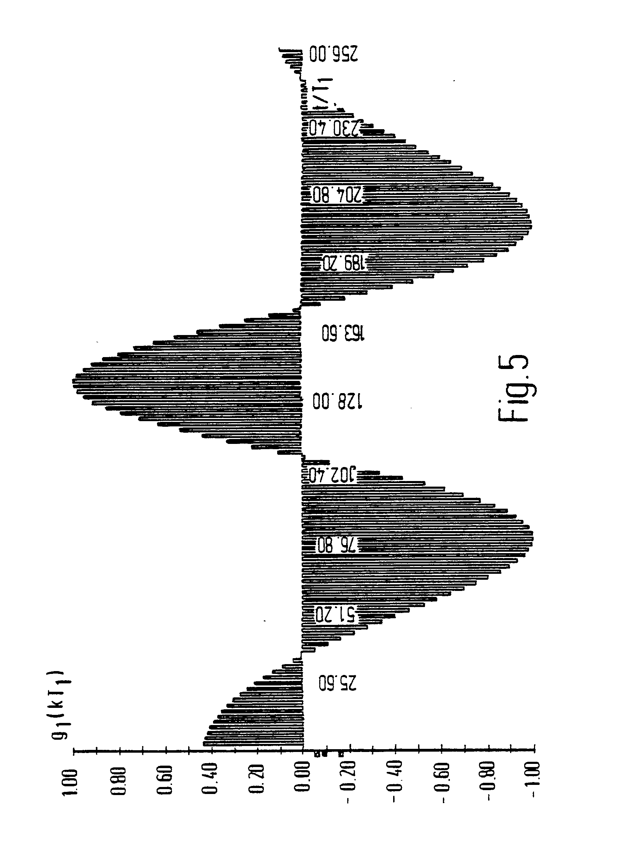

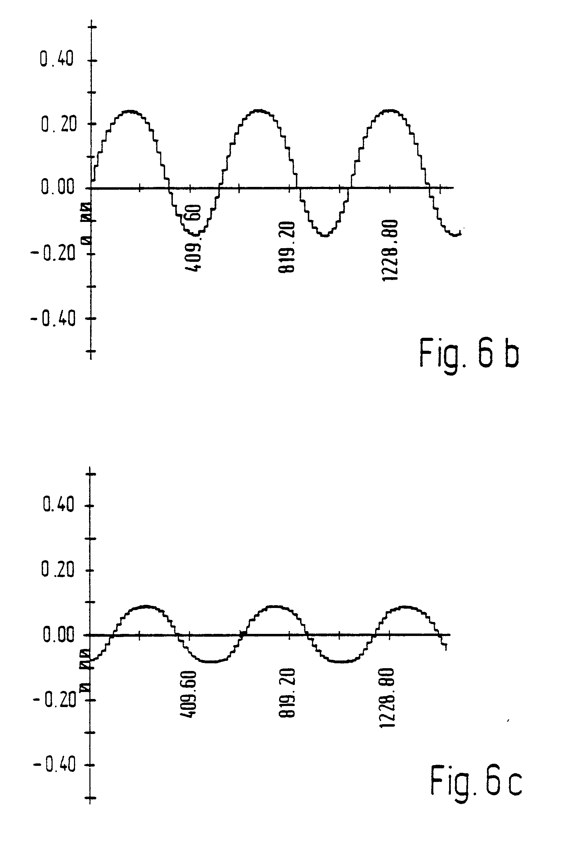

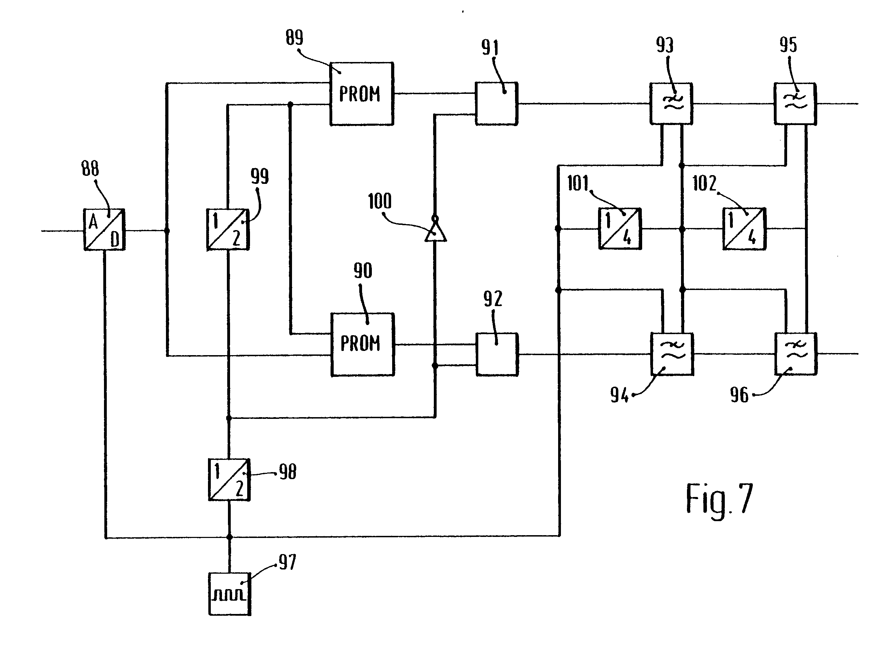

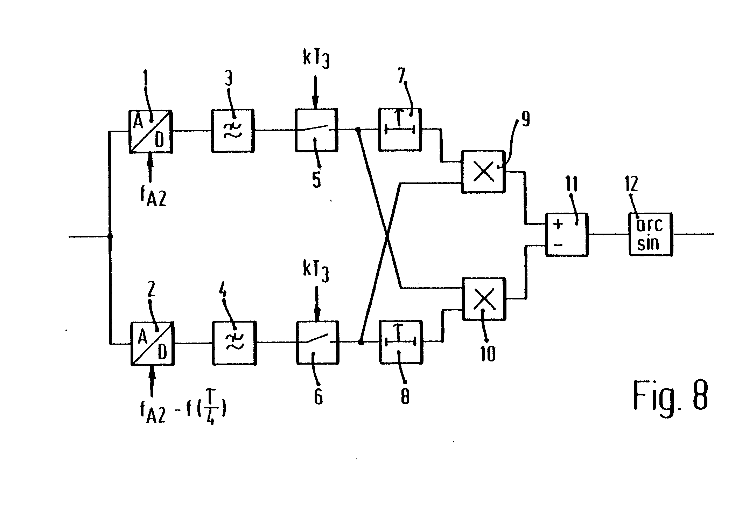

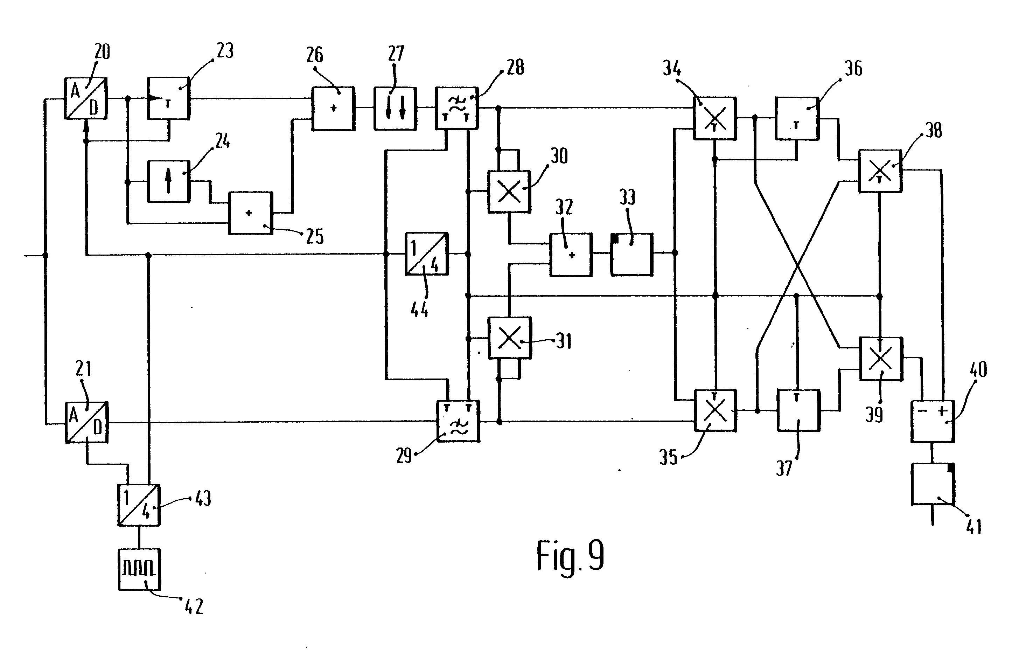

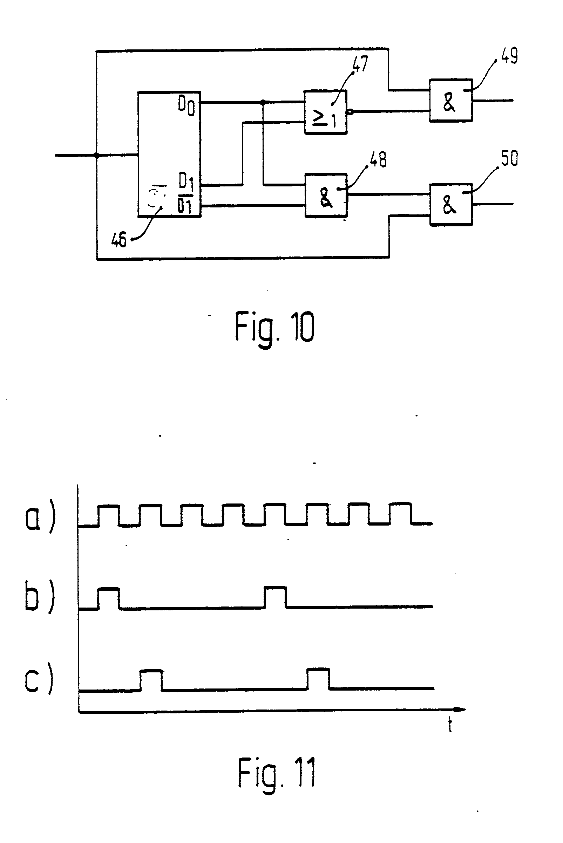

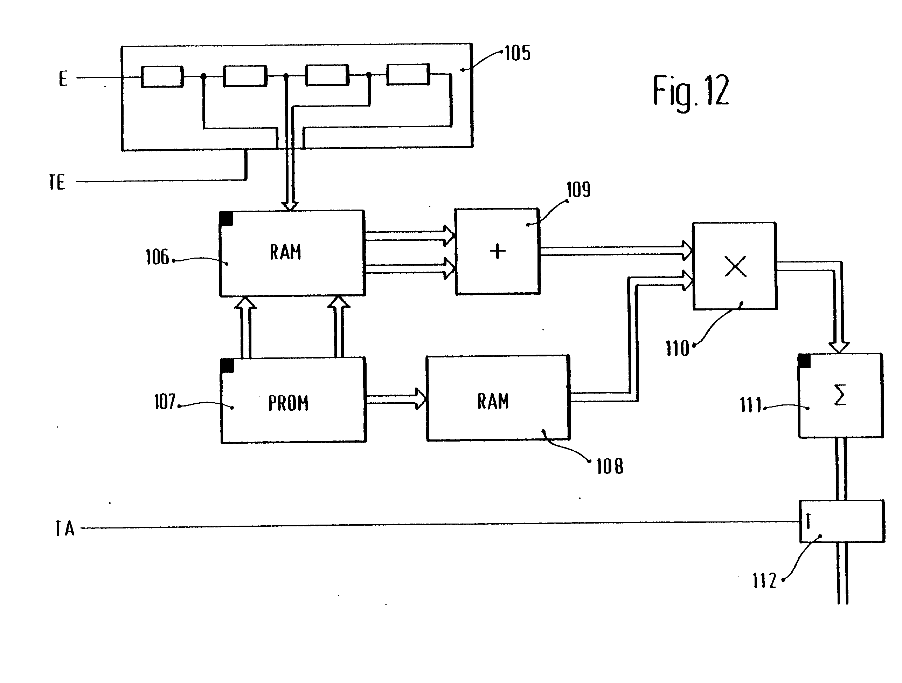

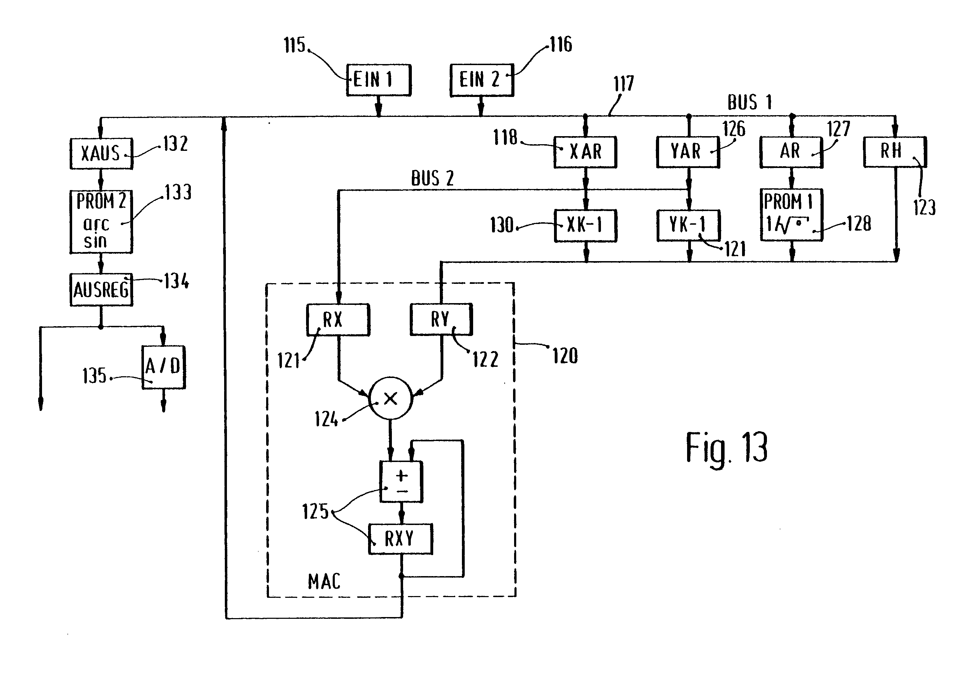

Ausführungsbeispiele der Erfindung sind in der Zeichnung dargestellt und in der nachfolgenden Beschreibung näher erläutert. Es zeigen : Figur 1 das Blockschaltbild eines digitalen FM-Demodulators, Figur 2 ein detailliertes Blockschaltbild des digitalen FM-Demodulators gemäß Bild 1, Figur 3 die Verläufe der Signalspektren an verschiedenen Punkten des Demodulators nach Figur 2, Figur 4 ein Beispiel eines frequenzmodulierten digitalisierten Signals, Figur 5 ein Signal nach der Trägermultiplikation, Figur 6 verschiedene digitale Ausgangssignale am Ausgang des Demodulators, Figur 7 ein praktisches Ausführungsbeispiel des Demodulators nach Figur 2, Figur 8 ein Blockschaltbild eines weiteren Demodulators in modifizierter Form, Figur 9 ein detailliertes Ausführungsbeispiel des Demodulators nach Figur 8, Figur 10 ein Schaltungsdetail des Demodulators nach Figur 9, Figur 11 ein Impulsdiagramm zur Erläuterung der Funktion der Schaltung nach Figur 10, Figur 12 der schaltungstechnische Aufbau eines nichtrekursiven Filters für die digitalen Demodulatoren und Figur 13 ein weiteres Beispiel zur Realisierung eines Demodulators.

Beschreibung der Ausführungsbeispiele

Die beschriebenen Demodulatoren eignen sich besonders zur Demodulation von Zwischenfrequenzsignalen von UKW-Rundfunkempfängern, wobei davon ausgegangen wird, daß die Zwischenfrequenz bei 10,7 MHz liegt. Die Demodulatoren sind auch zur Demodulation anderer frequenzmodulierter Signale geeignet, wie sie beispielsweise bei der trägerfrequenten Nachrichtenübertragung Verwendung finden.

Um die Demodulatoren preisgünstig fertigen zu können, ist es insbesondere wesentlich, die Integrationsdichte und die Verarbeitungsgeschwindigkeit digitaler Bausteine zu berücksichtigen. Die Demodulatoren wurden daher so ausgelegt, daß jedes Teilsystem jeweils mit der niedrigsten Abtastfrequenz betrieben werden kann, die systemtheoretisch möglich ist.

Zur Frequenzerkennung im Zwischenfrequenzbereich weisen Nulldurchgangsdiskriminatoren nach einfachen Zählverfahren wegen der hohen Zählfrequenzen Nachteile auf. Hohe Taktfrequenzen erfordern einerseits beim augenblicklichen Stand der Technologie eine hohe Verlustleistung, außerdem sind solche Bausteine teuer. Bei den erfindungsgemäßen Demodulatoren wird daher eine hohe Auflösung der Zeitachse entsprechend der Genauigkeit der Bestimmung der Momentanfrequenz aus Gründen zu hoher Abtastraten nicht realisiert. Die im folgenden beschriebenen Demodulationsprinzipien gehen von einer Herabmischung des Zwischenfrequenzsignals in den Basisbandbereich aus, wodurch der Demodulator die geringste Arbeitsfrequenz erfordert, die möglich ist. Die Figur 1 zeigt in einem Blockschaltbild einen digitalen FM-Demodulator. Das Eingangssignal des Demodulators ist analog und wird einem Zwischenfrequenzverstärker entnommen. Dieses Signal wird einem Analog-Digitalwandler 55 zugeführt. Am Ausgang des Analog-Digitalwandlers 55 steht ein digitales Wort an, das beispielsweise eine Länge von 8 Bit aufweist. Das digitale Wort wird jeweils einem Multiplizierer 56 und 57 zugeführt. Im Multiplizierer 56 erfolgt die Multiplikation mit einer Cosinusfunktion mit der nach der Abtastung vorliegenden Trägerfrequenz $f_0$, während im Multiplizierer 57 die Multiplikation mit einer Sinusfunktion erfolgt. Die Multiplizierer 56 und 57 arbeiten digital. Dem Multiplizierer 56 folgt ein digitales Tiefpaßfilter 58. Ebenso folgt dem Multiplizierer 57 ein digitales Tiefpaßfilter 59. Dem digitalen Tiefpaß 58 ist eine Verzögerungsschaltung 60 nachgeschaltet, die beispielsweise bei einem 16 bit breiten digitalen Wort durch 16 parallelgeschaltete Flip-Flops realisiert werden kann. Ebenso ist dem Tiefpaß 59 eine Verzögerungsschaltung 61 nachgeschaltet. Wegen des Quantisierungsrauschens ist am Filterausgang ein breiteres Wort als am Eingang des Filters vorzusehen. In einem Multiplizierer 62 wird das digitale Wort am Ausgang des Verzögerungsgliedes 60 mit dem digitalen Wort am Ausgang des Tiefpasses 59 multipliziert. In einem Multiplizierer 63 wird der Ausgang des Verzögerungsgliedes 61 mit dem Ausgang des digitalen Filters 58 multipliziert. Der digitale Ausgangswert des Multiplizierers 63 wird in einem Subtrahierer 64 von dem digitalen Ausgangswert des Multiplizierers 62 subtrahiert. Dem Subtrahierer 64 ist eine Arcus-Sinustafel 65 nachgeschaltet.

Am Analog-Digitalwandler 55 liegt ein frequenzmoduliertes Signal mit einer vorgegebenen Trägerfrequenz an, dessen Bandbreite durch die Durchlaßcharakteristik der Zwischenfrequenzfilter bestimmt ist. Die Analog-Digitalwandlung wird zu äquidistanten Zeitabschnitten vorgenommen, wobei der Analog-Digitalwandler 55 durch die Abtastfrequenz getaktet ist. Der minimale Wert der Abtastfrequenz bestimmt sich durch das Shannon'sche Abtasttheorem, dabei ist die Bandbreite des Zwischenfrequenzsignals maßgebend, wobei diese Bandbreite im wesentlichen durch die Bandbreite eines dem Analog-Digitalwandler 70 vorgeschalteten analogen Vorfilter bestimmt ist. In dem Multiplizierer 56 wird das am Ausgang des Analog-Digitalwandlers 55 anstehende digitale Wort mit einer Cosinusfunktion multipliziert. Diese Cosinusfunktion muß ebenfalls in digitaler Form anliegen. Bei diesem Ausführungsbeispiel ist die Abtastung so gewählt, daß nach dem Analog-Digital-Wandler 55 eine neue Zwischenfrequenz entsteht, die $f_0 = f_A/4$ beträgt, wobei $f_0$ die Mittenfrequenz am Ausgang des Analog-Digital-Wandler 55 und $f_A$ die Abtastfrequenz kennzeichnet. Allgemein lauten die Bedingungen für die zu erfüllende Abtastfrequenz

$$f_A = \frac{4\,f_{ZF}}{4\,N \pm 1}, \quad N = 1, 2, 3...$$

wobei die Bandbreite des analogen Vorfilters B

$$\frac{2\,f_{ZF}}{4\,N \pm 1}$$

sein muß. $f_{ZF}$ ist dabei die Zwischenfrequenz vor der Abtastung. Beträgt die Zwischenfrequenz z. B. 10,7 MHz und wählt man N = 1, ergibt sich nach den obigen Formeln eine Abtastfrequenz von 8,56 MHz. Die neue Mittenfrequenz $f_0$ am Ausgang des Analog-Digital-Wandlers beträgt dann 2,14 MHz. Aufgrund dieser Wahl der Abtastfrequenz erfolgt die digitale Multiplikation zum Zeitpunkt der Nulldurchgänge bzw. der Extremwerte der Cosinusfunktion. Die Multiplikation im Multiplizierer 56 erfolgt daher ausschließlich mit den Werten + 1, 0 und — 1, so daß sich die Multiplikation schaltungstechnisch auf eine Vorzeichenumkehr reduziert. Da die Multiplikation ansonsten in Echtzeit erfolgen müßte, ergibt sich dadurch eine wesentliche Schaltungsvereinfachung. Im digitalen Multiplizierer 57 erfolgt die Multiplikation mit einer Sinusfunktion. Durch die entsprechende zuvor erläuterte Wahl der Abtastfrequenz läßt sich erreichen, daß die Multiplikation ebenfalls nur mit den Werten 1, 0 und — 1 erfolgen muß, so daß wiederum lediglich eine Vorzeichenumkehr zu realisieren ist. An den Ausgängen der Multiplizierer 56 und 57 liegen nunmehr Signale an, die neben dem Basisbandsignal einen weiteren Term enthalten, der die doppelte Trägerfrequenz enthält. Durch die anschließende Tiefpaß-Filterung durch die digitalen Tiefpässe 58 und 59 werden die Signale unterdrückt, die die doppelte Trägerfrequenz enthalten. Die Ausgangssignale der Filter 58 und 59 sind zueinander Hilbert-transformiert.

Die Ausgangssignal der Tiefpässe stellen Cosinus- bzw. Sinussignale dar, deren Argumente das Intergral des Nutzsignals enthalten. Es handelt sich also um FM-Signale mit dem Träger 0. Am Ausgang des Tiefpasses 58 liegt der Term

$$\frac{1}{2} \cos \left[ \Delta\Omega \int_{-\infty}^{t} v \, dT \right]$$

an, während am Ausgang des Tiefpasses 59 das Signal

$$-\frac{1}{2} \sin \left[ \Delta\Omega \int_{-\infty}^{t} v \, dT \right]$$

anliegt. Hierbei ist $\Delta\Omega$ der Frequenzhub und v das in den Grenzen von $-1$ bis $+1$ ausgesteuerte dimensionslose Nutzsignal. Hieraus ist, etwa durch Arcus-Cosinus-Bildung das Ausgangssignal des Tiefpasses 58 nicht eindeutig zu ermitteln, da das Intergral von v den Argumentbereich $\pm \pi/2$ beliebig überschreitet. Die Lösung ist deshalb vieldeutig.

Es muß daher eine Differenzbildung des Argumentes derart erfolgen, daß dieses innerhalb eines definierten Intervals bleibt. Dies gelingt durch die nachfolgend beschriebene Operation :

$$g(kT) = -\frac{1}{2} \sin \left[ \Delta\Omega \int_{-\infty}^{(k-1)T} v(\tau) \, d\tau \cdot \frac{1}{2} \cos \left[ \Delta\Omega \int_{-\infty}^{kT} v(\tau) \, d\tau \right. \right.$$

$$= +\frac{1}{8} \left\{ \sin \left[ \Delta\Omega \int_{(k-1)T}^{kT} v(\tau) \, d\tau \right] - \sin \left[ 2 \Delta\Omega \int_{-\infty}^{(k-1)T} v(\tau) \, d\tau + \right. \right.$$

$$\left. \left. + \Delta\Omega \int_{(k-1)T}^{kT} v(\tau) \, d\tau \right] \right\} , \quad k = 1, 2, \ldots$$

Für hinreichend hohe Abtastfrequenzen ist die Vereinfachung

$$\int_{(k-1)T}^{kT} v(\tau) \, d\tau \simeq v(kT) \cdot T,$$

zulässig. Diese Vereinfachung hat ausschließlich lineare Verzerrungen des niederfrequenten Signals zur Folge (schwache Tiefpaßwirkung), die nach der Demodulation sehr einfach kompensiert werden können.

Zur Realisierung dieser Verknüpfung wird das digitale Ausgangssignal des Tiefpaß 59 mit dem ersten Vergangenheitswert des Ausgangssignals des Tiefpasses 58 multipliziert. Das Verzögerungsglied 60 hat daher die Aufgabe, das Ausgangssignal des Tiefpasses 58 um einen Takt zu verzögern, was einfach durch Speicherglieder, beispielsweise durch eine Flip-Flop-Kette entsprechend der Wortbreite zu erreichen ist. Ebenso wird das Ausgangssignal des Tiefpasses 58 durch den Multiplizierer 63 mit dem ersten Vergangenheitswert des Ausgangssignals des Tiefpasses 59 multipliziert. Am Ausgang des Multiplizierers 62 liegt nunmehr das Signal

$$g(kT) \simeq \frac{1}{8} \left\{ \sin \left[ \Delta\Omega v(kT) \cdot T \right] - \sin \left[ 2 \Delta\Omega \int_{-\infty}^{(k-1)T} v(\tau) \, d\tau + \Delta\Omega v(kT) \cdot T \right] \right\}$$

an, während am Ausgang des Multiplizierers 63 das Signal

$$g(kT) \simeq \frac{1}{8} \left\{ - \sin \left[ \Delta\Omega v(kT) \cdot T \right] - \sin \left[ 2 \Delta\Omega \int_{-\infty}^{(k-1)T} v(\tau) \, d\tau + \Delta\Omega v(kT) \cdot T \right] \right\}$$

auftritt.

Nach einer Subtraktion der beiden Ausgangsignale der Multiplizierer 62 und 63 durch den Subtrahierer 64 ist das demodulierte Ausgangssignal als Sinusfunktion abgreifbar. Das Ausgangssignal des Subtrahierers 64 hat dabei die Form

$$1/4 \sin (\Delta\Omega \cdot v \cdot (kT) \cdot T)$$

Durch eine Arcus-Sinustafel 65, die beispielsweise in einem ROM abgelegt ist, kann durch die Arcus-Sinusoperation das Nutzsignal eindeutig gewonnen werden. Voraussetzung für die Eindeutigkeit ist jedoch, daß das Argument dieses Sinusausdrucks in den Grenzen zwischen $-\pi/2$ und $+\pi/2$ bleibt, so daß das Nutzsignal aus der Arcus-Sinusoperation eindeutig zu gewinnen ist. Diese Bedingung führt zu einer minimalen Abtastfrequenz des Demodulators, die nicht unterschritten werden darf. Bei einem Frequenzhub von 75 KHz, wie er beispeilsweise bei Rundfunksendungen üblich ist, ergibt sich somit eine minimale Abtastfrequenz des Demodulatorteils von 300 KHz. Vorteilhaft ist es, die Abtastfrequenz etwas größer zu wählen, beispielsweise im Bereich von 500 KHz. Aufgrund der niedrigen möglichen Abtastfrequenzen nach der Filterung ist es vorteilhaft, die Abtastrate an den Ausgängen der Tiefpaßfilter 58 und 59 zu reduzieren. Ein praktisches Ausführungsbeispiel wird später gezeigt. Da gleichzeitig das

4

Shannon'sche Abtasttheorem zu erfüllen ist, darf die Bandbreite der Tiefpaßfilter die halbe Abtastfrequenz nicht überschreiten.

Frequenzverstimmungen im analogen Mischteil bewirken im Demodulator das Entstehen einer digitalen Gleichkomponente, so daß der Gleichanteil gegebenenfalls zur Nachregelung der Abstimmung benützt werden kann (AFC).

Für die korrekte Funktion des Demodulators ist eine konstante Amplitude des frequenzmodulierten Signals erforderlich. Amplitudenschwankungen müssen daher zunächst durch einen analogen Regelverstärker im ZF-Kreis ausgeregelt werden. Nur so ist eine optimale Aussteuerung des Analog-Digitalumsetzers möglich. Schnelle Amplitudenschwankungen, die sich beispielsweise als AM-Störungen äußern, werden günstigerweise digital durch einen Multiplizierer im Signalpfad ausgeregelt. Ein Kriterium für den erforderlichen Verstärkungsfaktor ist aus den Ausgangssignalen der Tiefpaßfilter 58 und 59 zu gewinnen. Die Summe der Quadrate der Ausgangssignale der Tiefpaßfilter 58 und 59 entspricht für jeden Abtastzeitpunkt dem Quadrat der Momentanamplitude. Damit ist eine Korrektur der Amplitude bei jedem Abtastwert möglich. Multiplikative Amplitudenfehler können somit schnell ausgeregelt werden. Einzelheiten über den Entwurf digitaler Filter, wie der Filter 58 und 59, sind z. B. dem Buch Schüßler, Digitale System zur Signalverarbeitung, Springer Verlag Berlin, Heidelberg, New York, 1973 zu entnehmen.

Anzustreben ist der Einsatz nichtrekursiver Filter, da sie den Vorteil der linearen Phase bieten. Eine solche Lösung ist attraktiv, weil aufgrund einer exakt konstanten Gruppenlaufzeit die nichtlinearen Verzerrungen des NF-Signals vermindert und die Stereo-Kanaltrennung erheblich verbessert werden können. Nichtrekursive Filter erfordern einen hohen Multiplikationsaufwand, der nur dadurch verringert werden kann, daß die Abtastfrequenzen in jedem Teilsystem so gering wie möglich gewählt werden und zusätzlich am Ausgang eine Unterabtastung erfolgt. Ähnliches gilt auch für den Analog-Digitalumsetzer. Zur korrekten Erfassung eines ungefilterten Ausgangssignals am ZF-Mischer sind Abtastfrequenzen in der Größenordnung von 50 MHz erforderlich, wenn man das Shannon'sche Abtasttheorem anwendet. Dieser Wert kann erheblich reduziert werden, wenn dem Analog-Digitalumsetzer ein analoger Bandpaß vorgeschaltet ist, dessen Mittenfrequenz auf der Trägerfrequenz liegt. Dies kann beispielsweise die Zwischenfrequenz bei 10,7 MHz sein. Dieser Bandpaß sollte einerseits so breitbandig sein, daß das Nutzsignal im Frequenzbereich keine merkbaren Phasenverzerrungen erfährt. Andererseits ist seine Bandbreite hinreichend gering zu wählen, so daß sich eine wirksame Reduktion der Abtastrate des Analog-Digitalumsetzers ergibt. Für den UKW-Rundfunkempfang mit einem Frequenzhub von ± 75 KHz ist beispielsweise eine Bandbreite von 2 MHz vorteilhaft. Mit diesen Zahlenbeispielen soll das Blockschaltbild eines digitalen Demodulators mit nichtrekursiven Filtern nach Figur 2 erläutert werden.

Einem nicht dargestellten Zwischenfrequenzverstärker mit einem Bandfilter folgt ein Analog-Digitalwandler 70, an dessen Ausgang jeweils ein Multiplizierer 71 und 72 angeschlossen ist. Im Multiplizierer 71 erfolgt die digitale Multiplikation mit einer Cosinusfunktion, während im Multiplizierer 72 die digitale Multiplikation mit einer Sinusfunktion erfolgt. Durch geeignete Wahl der Abtastfrequenz des Analog-Digital-Umsetzers läßt sich erreichen, daß schaltungstechnisch nur eine Vorzeichenumkehr erfolgen muß. Dem Multiplizierer 71 folgt ein nichtrekursives Filter 73, dessen Ausgangssignal durch einen Schalter 75 mit einer niedrigeren Frequenz abgetastet wird. Dem Schalter 75 folgt ein weiteres nichtrekursives Filter 77, dessen Ausgangssignal mittels eines Schalters 79 nochmals abgetastet wird. Der Schalter 79 arbeitet mit einer niedrigeren Frequenz als der Schalter 75. Technisch auszuführen ist ein solcher Schalter durch ein Register, das so getaktet wird, daß — z. B. bei einem Unterabtastungsfaktor 4 — nur jeder vierte Wert seiner Eingangsdatenfolge übernommen wird. Das Ausgangssignal des Schalters 79 wird um jeweils eine Taktzeit durch das Verzögerungsglied 81 verzögert.

Das Ausgangssignal des Multiplizierers 72 wird ebenso aufbereitet. Dem Multiplizierer 72 folgt das nichrekursive Filter 74, dessen Ausgangssignal mit dem Schalter 76 abgetastet wird. Die Taktfrequenz für die Schalter 75 und 76 ist gleich. Dem Schalter 76 folgt ein weiteres nichtrekursives Filter 78, dessen Ausgangssignal über einen Schalter 80 abgefragt wird. Die Taktfrequenz des Schalters 80 ist identisch mit der Taktfrequenz des Schalters 79. Das Ausgangssignal des Schalters 80 wird einerseits einem Eingang des digitalen Multiplizierers 83 andererseits dem Verzögerungsglied 82 zugeführt, das das Ausgangssignal des Schalters 80 um einen Taktimpuls verzögert. Der weitere Eingang des Multiplizierers 83 wird durch das Ausgangssignal des Verzögerungsgliedes 81 gespeist. An den Eingängen eines Multiplizierers 84 liegen einerseits das Ausgangssignal des Schalters 79, andererseits das Ausgangssignal des Verzögerungsgliedes 82 an. Das Ausgangssignal des Multiplizierers 84 wird von dem Ausgangssignal des Multiplizierers 83 in einer digitalen Subtrahierstufe subtrahiert. Der Subtrahierstufe 85 kann wieder die Arcus-Sinus-Tafel 86 folgen.

Ein Taktgenerator 67 liefert die Taktfrequenz für den Analog-Digitalwandler 70. An den Taktgenerator 67 ist ein 1 : 4 Teiler 68 angeschlossen, der die Taktfrequenz für Schalter 75 und 76 liefert. Dem Ausgang des Teilers 68 folgt ein weiterer Teiler 69, der das Taktsignal nochmals durch vier teilt. Das Ausgangssignal des Teilers 69 dient zur Steuerung der Schalter 79 und 80.

Die Wirkungsweise dieser Schaltungsanordnung sei anhand der Figuren 3 bis 6 näher erläutert. In den Figuren 4 und 5 sind die digitalen Signalwerte als Amplituden in der Ordinate aufgetragen.

Durch den Analog-Digitalwandler 70 soll das Eingangssignal mit einer möglich geringen Abtastfrequenz abgetastet werden, jedoch so, daß das Abtasttheorem erfüllt ist. Dazu muß der Taktgenerator 67 ein Signal liefern, dessen Frequenz mindestens den doppelten Wert der Bandbreite des analogen Bandpasses vor dem Analog-Digitalwandler 70 besitzt. Als weitere Bedingung ist zu beachten, daß durch die Abtastung das ursprüngliche Zwischenfrequenzsignal in eine niedrigere ZF-Lage $f_0$ transformiert wird, wobei im Interesse einer einfachen Ausführung der Multiplizierer 71 und 72 die ZF-Frequenz 1/4 der Abtastfrequenz betragen soll. Dies ist zu erreichen, wenn für die Abtastfrequenz beispielsweise eine Frequenz gewählt wird, die 4/5 der Eingangszwischenfrequenz beträgt. Ist die Bandbreite des vorhergehenden Zwischenfrequenzfilters beispielsweise 2 MHz und beträgt die Zwischenfrequenz 10,7 MHz, so ist eine geeignete Abtastfrequenz beispielsweise 8,56 MHz. Aufgrund der zuvor dargelegten Formeln ergibt sich dann eine niedrigere ZF-Lage bei 1/4 der Abtastfrequenz, so daß die niedrigere ZF-Lage bei 2,14 MHz liegt.

Wie die Figur 3a zeigt, entsteht unter anderem bei der Trägerfrequenz von 2,14 MHz ein neues FM-Spektrum, wobei dieses digitale Spektrum gemäß der analogen Vorfilterung eine Bandbreite von 2 MHz aufweist. Nach der Quadraturdemodulation durch die Multiplizierer 71 und 72 entsteht dabei neben dem Basisbandsignal gemäß Figur 3b jeweils ein Spektrum um die doppelte Trägerfrequenz. Bei einer Trägerfrequenz von 2,14 MHz ist dies 4,28 MHz. Dieses zusätzliche Spektrum wird durch die nichtrekursiven Filter 73 und 74 unterdrückt. Das Frequenzverhalten dieser nichtrekursiven Filter ist in gestrichelten Linien in der Figur 3b eingezeichnet. Da die maximale Frequenz des Ausgangssignals der Tiefpaßfilter 73 und 74 in etwa 1 MHz beträgt, kann die Abtastfrequenz an den Ausgängen der Tiefpässe um den Faktor 4 reduziert werden. Die Schalter 75 und 76 fragen daher das Ausgangssignal der Tiefpässe 73 und 74 mit einer Frequenz von etwa 2,14 MHz ab. Dieser Schritt ist insofern wesentlich, als damit für die nun folgende selektive Schmalbandfilterung der Aufwand stark reduziert wird. Würde nämlich diese Aufgabe von den Tiefpässen 73 und 74 mit übernommen, so würde bei der dort vorliegenden vierfachen Abtastfrequenz der Filtergrad gegenüber den folgenden Filtern um den Faktor 4 höher liegen. Die nichtrekursiven Filter 77 und 78 haben die Aufgabe, aus dem 1 MHz breiten Basisband das Nutzsignal herauszufiltern, dessen Bandbreite beim UKW-Rundfunk auf etwa 150 KHz begrenzt ist. Das Verhalten dieser Tiefpaßfilter ist in Figur 3c dargestellt. Die minimale erforderliche Abtastfrequenz beträgt also um 300 KHz. Dieser Wert entspricht auch etwa der minimalen Abtastfrequenz, die bei der Schaltungsanordnung nach Figur 1 für die Eindeutigkeit der Arcus-Sinusoperation erforderlich war. In einem konkreten Ausführungsbeispiel wurde die Abtastfrequenz für die Schalter 79 und 80 mit 535 KHz festgelegt. Die Weiterverarbeitung dieses Signals erfolgt über die Multiplizierer 83 und 84 sowie dem Subtrahierer 85, wobei die gleichen Vorgänge ablaufen, die bereits anhand der Figur 1 erläutert worden sind.

Der entscheidende Aufwand der hier beschriebenen Schaltungsanordnung liegt in der Realisierung des zweiten nichtrekursiven Filterpaares, über die Einzelheiten in der genannten Literaturstelle nachzulesen sind. Wie aus Figur 3b erkennbar ist, ist die Flankensteilheit des ersten Tiefpaßfilters im wesentlichen durch den Abstand zwischen dem Basisband und dem darauffolgenden Band bestimmt. Weiterhin ist maßgebend für die Dimensionierung die erwartete Sperrdämpfung. Wählt man bei dem ersten nichtrekursiven Tiefpaß die 6 dB-Grenzfrequenz bei einer Frequenz von 2,14 MHz und berechnet jetzt das Filter nach dem Verfahren der modifizierten Fourierapproximation, so ergibt sich bei einer Sperrdämpfung von beispielsweise 65 dB ein Filtergrad von 18, wobei wegen der Nyquistflanke um $f_A/4$ die Hälfte aller Koeffizienten Null wird. Wegen der Linearphasigkeit der nichtrekursiven Filter sind weiterhin die Filterkoeffizienten paarweise gleich. Insgesamt sind für die digitale Filterung jeweils fünf Multiplikationen durchzuführen, so daß für jede Multiplikation in etwa 1/5 der Ausgangs-Abtastfrequenz des Filters zur Verfügung steht.

Der hauptsächliche Aufwand bei dieser Schaltungsanordnung verbleibt bei dem Tiefpaßfilterpaar 77 und 78, das vollständig den Tiefpaßfiltern 3 und 4 und 95 und 96 entspricht. Dieses System arbeitet mit einer Eingangsabtastfrequenz von 2,14 MHz. Bei der Bestimmung dieses Filters, bei dem ein Frequenzverlauf mit einer cosinus-Roll-off-Flanke angestrebt wurde, wurde ebenfalls die modifizierte Fourierapproximation zur Berechnung angewendet. Bei einer 6 dB-Durchlaßfrequenz von 80 KHz ergab sich ein Filter vom Grad 38. Setzt man hierbei symmetrische Koeffizienten an, so sind jeweils 19 Multiplikationen während einer Taktzeit bei einer Taktfrequenz von 2,14 MHz durchzuführen. Als Realisierung bietet sich dazu das Verfahren der sogenannten « verteilten Arithmetik » an, bei der Multiplizierer und Addierer durch ein gewissen Aufwand an Festwertspeichern und einem Akkumulator ersetzt werden.

Die Figur 4 zeigt das digitalisierte FM-Signal, wie es am Ausgang des Analog-Digitalwandlers 70 in Form von digitalen Worten anliegt. In Figur 5 ist das Ausgangssignal des Multiplizierers 71 dargestellt. Die Transformation in das Basisband ist bereits zu erkennen. Figur 6 zeigt das Ausgangssignal nach dem Subtrahierer 85. Die Figur 6a zeigt dabei ein Ausganssignal, wie es bei einer Übermodulation des Trägers am Ausgang auftritt. In Figur 6b ist das digitale Signal gezeigt, das bei einer Frequenzverstimmung am Ausgang des Demodulators auftritt. Es ist deutlich der Gleichanteil zu erkennen, der gegebenenfalls zu einer automatischen Frequenznachregelung Verwendung findet. In Figur 6c ist ein niederfrequentes Signal mit einer FM-Bandbegrenzung aufgezeigt.

Die Figur 7 zeigt ein konkretes Ausführungsbeispiel eines Demodulators nach dem Blockschaltbild in Figur 2. Das Eingangssignal gelangt an einen Analog-Digitalwandler 88, dessen Ausgangssignal jeweils einem PROM 89 und 90 zugeführt ist. Der Ausgang des PROM's 89 führt zu einem Eingang einer UND-Glied-Kette 91, während der Ausgang des PROM's 90 zu einem Eingang einer UND-Glied-Kette 92 führt. Der Ausgang der UND-Glied-Kette 91 führt zu einem nichtrekursiven Filter 93. Der Ausgang des nichtrekursiven Filters 93 führt zu dem Eingang eines weiteren nichtrekursiven Filters 95. Der Ausgang des nichtrekursiven Filters 95 führt zu dem in Figur 2 dargestellten Verzögerungsglied 81 bzw. zum digitalen Multiplizierer 84. An den Ausgang der UND-Glied-Kette 92 ist das nichtrekursive Filter 94 angeschlossen. Dessen Ausgang führt zum Eingang des nichtrekursiven Filters 96. Der Ausgang des nichtrekursiven Filters 96 führt einerseits zu dem in Figur 2 dargestellten Verzögerungsglied 82 und zu einem Eingang des Multiplizierers 83. Ein Taktgenerator 97 versorgt den Analog-Digitalwandler 88, den Tiefpaß 94 und den Tiefpaß 93 mit den Taktsignalen. Ein Teiler 98 ist an den Taktgenerator 97 angeschlossen und dividiert die Taktfrenquenz durch zwei. Der Ausgang des Taktgenerators 98 wird zu einem weiteren Eingang der UND-Glied-Kette 92 und über den Inverter 100 zu einem weiteren Eingang der UND-Glied-Kette 91 geführt. Weiterhin folgt dem Teiler 98 ein Teiler 99, der ebenfalls durch zwei teilt. Der Ausgang des Teilers 99 führt zu jeweils einem Takteingang der PROM's 89 und 90. Der Ausgang des Taktgenerators 97 führt desweiteren zu einem Teiler 101, der die Taktfrequenz durch vier teilt. Mit dem Ausgangssignal des Teilers 101 wird der Ausgang der nichtrekursiven Filter 93 und 94 und der Eingang der nichtrekursiven Filter 95 und 96 getaktet. An den Ausgang des Teilers 101 ist ein weiterer Teiler 102 angeschlossen. Mit dem Ausgangssignal dieses Teilers 102, der ebenfalls durch vier teilt, werden die Ausgangssignale der nichtrekursiven Filter 95 und 96 getaktet.

Diese Schaltungsanordnung ist ein einfaches realisierbares Beispiel des Blockschaltbilds nach Figur 2. Der Taktgenerator 97 schwingt bei dem Beispiel bei einer Frequenz von 8,56 MHz, wenn am Eingang des Analog-Digitalwandlers ein Signal mit einer Mittenfrequenz von 10,7 MHz und einer Bandbreite von 2 MHz anliegt. Nach der Analog-Digitalwandlung liegen die digitalen Signale an den Eingängen der ROM's 89 und 90 an. Die ROM's übernehmen die Aufgabe, ein am Eingang anstehendes digitales Wort in Abhängigkeit von dem Signal am Takteingang entweder unverändert an den Ausgang anzulegen oder das invertierte digitale Wort an den Ausgang weiterzugeben. Durch die Teilung durch vier durch die beiden Teiler 98 und 99 wird bewirkt, daß jedes vierte Wort, das am Eingang des ROM's anliegt invertiert wird. Durch die UND-Glieder 91 und 92 wird dieses zweite digitale Wort aufgrund des Teilers 98 gesperrt. Durch diese Maßnahme wird erreicht, daß die Multiplikation mit dem Cosinus bzw. die Multiplikation mit dem Sinus entfällt sondern jeweils die Datenworte an den Extremwerten 1 und — 1 sowie an den Nulldurchgängen der Cosinus- und Sinusfunktion erfolgen. Das digitale Signal am Ausgang der UND-Glied-Kette 91 entspricht daher dem Ausgangssignal am Analog-Digitalwandler 88, wobei jedoch die Signalfolge jeweils mit 1, 0, — 1, 0, etc. multipliziert ist. Am Ausgang der UND-Glied-Kette 92 entsteht die Signalfolge des Ausganges des Analog-Digitalwandlers 88, wobei dieses Signal mit der Signalfolge 0, 1, 0, — 1 etc. multipliziert ist. Auf diese Art und Weise lassen sich die relativ teueren Multiplizierer bei den hohen Taktfrequenzen umgehen. Ein Ausführungsbeispiel für die nichtrekursiven Filter 93 bis 96 wird später aufgezeigt.

Wählt man eine etwas anders geartete Abtastung, so ist es möglich, die Filter 73 und 74 bzw. die Filter 93 und 94 ganz entfallen zu lassen. Hierbei sind zwei Analog-Digitalwandler erforderlich, die mit 1/4 der Abtastfrequenz des Analog-Digital-Wandlers 88 betrieben werden ($f_{A2}=f_A/4$) und bei denen weiterhin die Abtastung um $T_2/4$ verschoben vorgenommen wird. Das Blockschaltbild dieses Prinzips ist in Figur 8 dargestellt. Das Ausgangssignal des Zwischenfrequenzverstärkers führt einerseits zu einem Analog-Digitalwandler 1 und andererseits zu einem Analog-Digitalwandler 2. Die Abtastung des Analog-Digitalwandlers 1 erfolgt zum Analog-Digitalwandler 2 um $T_2/4$ phasenverschoben. Dem Analog-Digitalwandler 1 folgt ein Tiefpaß 3, der wiederum als nichtrekursives Filter ausgebildet ist. Durch einen Schalter 5 wird das Ausgangssignal des Tiefpasses 3 unterabgetastet, wobei die Abtastfrequenz um den Faktor 4 reduziert ist. Dem Schalter 5 folgt ein Verzögerungsglied 7, dessen Ausgang zu einem Eingang eines Multiplizierers 9 führt. Dem Analog-Digitalwandler 2 folgt ein Tiefpaß 4, dessen Ausgangssignal von einem Schalter 6 abgefragt wird. Das Ausgangssignal des Schalters 6 tastet mit einer um den Faktor 4 reduzierten Abtastrate das Signal des Tiefpasses 4 ab. Der Schalter 5 und der Schalter 6 werden mit der gleichen Abtastfrequenz betrieben. Der Ausgang des Schalters 6 führt einerseits zu einem Eingang des Multiplizierers 9 andererseits zu einem Verzögerungsglied 8, dessen Ausgang zu einem Eingang eines Multiplizierers 10 geführt wird. An den anderen Eingang des Multiplizierers 10 ist der Ausgang des Schalters 5 angeschlossen. Der Ausgang des Multiplizierers 10 wird in einer Differenzierstufe 11 vom Ausgang des Multiplizierers 9 subtrahiert. Der Ausgang des Subtrahierers 11 wird einer Arcus-Sinustafel zugeführt.

Durch die relative Zeitverschiebung in der Abtastung der Analog-Digitalwandler um T/4 sind die Ausgangssignale nicht mehr exakt zueinander Hilbert-transformiert. Dies könnte in einem der nachfolgenden Tiefpässe 3 oder 4 kompensiert werden. Dadurch geht allerdings die Koeffizientensymmetrie zumindest in einem dieser beiden hochgradigen Filter verloren, was einen erheblichen Mehraufwand in der Realisierung der Schaltung der Filter bewirkt. Eine einfache Möglichkeit besteht darin, daß sich der durch die versetzte Abtastung ergebende Fehler durch eine lineare Interpolation ausgeglichen wird.

Durch den Wegfall des einen Tiefpaßfilters kann die Abtastfrequenz für die Analog-Digitalwandler bei dem beim UKW-Rundfunkempfang in der ZF-Stufe gegebenen Bedingungen beispielsweise mit 2,14 MHz gewählt werden. Durch diese Abtastung erfolgt eine direkte Mischung auf das Basisband. Die Abtastfrequenz $f_{A2}$ muß größer sein als die Bandbreite des vorgeschalteten analogen Bandpasses, außerdem muß das Verhältnis von Zwischenfrequenz und Abtastfrequenz ganzzahlig sein.

Wählt man als ganze Zahl 5, so ergibt sich für die Abtastfrequenz $f_{A2}$ eine Frequenz von 2,14 MHz. Die

**0 080 014**

Schalter 5 und 6 tasten vorteilhafterweise mit dem vierten Teil der Frequenz der Analog-Digitalwandler ab. Ihre Abtastfrequenz beträgt daher 535 KHz.

Die Figur 9 zeigt ein ausführliches Blockschaltbild zur Realisierung eines Demodulators nach Figur 8. Zur Korrektur der zeitversetzten Abtastung wird hierbei das Verfahren der linearen Interpolation und zur Amplitudenkorrektur die Quadrierung der Hilbert-transformierten Signale angewandt. Das analoge Ausgangssignal des Zwischenfrequenzfilters wird einem Analog-Digitalwandler 20 und einem Analog-Digitalwandler 21 zugeführt. Das Ausgangssignal des Analog-Digitalwandlers 20 gelangt einerseits an ein Verzögerungsglied 23, das als Flip-Flop-Gruppe ausgebildet ist. Andererseits ist das Ausgangssignal des Analog-Digitalwandlers einem Addierer 25 und einem Ein-Bitshifter 24 nach links zugeführt, was einer Multiplikation des Wortes mit 2 entspricht. Das Ausgangssignal des Ein-Bitshifters 24 wird zu einem weiteren Eingang des Addierers 25 geführt. Der Ausgang des Addierers 25 und der Ausgang des Verzögerungsgliedes 23 führt jeweils zu einem Eingang eines Addierers 26. An den Ausgang des Addierers 26 ist ein Rechtsshifter 27 angeschlossen, durch den um zwei Bits nach rechts geshiftet wird. Dieses entspricht einer Multiplikation des Wortes mit 1/4. Dem Shifter 27 folgt der Eingang des nichtrekursiven Filters 28. Der Ausgang des nichtrekursiven Filters 28 führt zu einem Quadrierer 30, dessen Ausgang wiederum mit einem Eingang eines Addierers 32 verbunden ist. Der Ausgang des Addierers 32 führt zu einem Eingang eines PROM's 33. Der Ausgang des PROM's 33 sowie der Ausgang des rekursiven Filters 28 wird jeweils einem Eingang eines Multiplizierers 34 zugeführt. Der Ausgang des Multiplizierers 34 führt zu einem Verzögerungsglied 36, dessen Ausgang wiederum zu einem Eingang eines Multiplizierers 38 gefürt ist.

Das Ausgangssignal des Analog-Digitalwandlers 21 führt zum Eingang eines nichtrekursiven Filters 29, dessen Ausgang wiederum einerseits mit einem Quadrierer 31, andererseits mit einem Eingang eines Multiplizierers 35 verbunden ist. Der Ausgang des Quadrierers 31 führt zu einem weiteren Eingang des Addierers 32. Der Ausgang des PROM's 33 ist ebenfalls an einen Eingang des Multiplizierers 35 angeschlossen. Das Ausgangssignal des Multiplizierers 35 führt einerseits zu einem Eingang des Multiplizierers 38 und andererseits über ein Verzögerungsglied 37 zu einem Eingang des Multiplizierers 39. Der andere Eingang des Multiplizierers 39 ist mit dem Ausgang des Multiplizierers 34 verbunden. Die Ausgänge der Multiplizierer 38 und 39 sind einem Subtrahierer 40 zugeführt. Der Ausgang des Addierers 40 führt zu einem ROM 41, das die Arcus-Sinustafel enthält. Am Ausgang der Arcus-Sinustafel 41 ist das digitale demodulierte Signal abgreifbar.

Ein Taktgenerator 42 schwingt mit dem vierfachen der maximalen Abtastfrequenz. Das Ausgangssignal des Taktgenerators 42 ist einem Teiler 43 zugeführt, der zwei um $T_2/4$ versetzte Ausgangssignale liefert. Mit dem einen Ausgangssignal wird der Analog-Digitalwandler 21 mit einem weiteren Ausgangssignal der Analog-Digitalwandler 20 getaktet. Dieser Taktimpuls führt weiterhin zum Verzögerungsglied 23 und zu den Übernahmeeingängen der nichtrekursiven Filter 28 und 29. Weiterhin ist an den Teiler 43 ein Teiler 44 angeschlossen, der eine Teilung durch vier vornimmt. Mit dem Ausgangssignal des Teilers 44 werden die Ausgangstaktsignale der nichtrekursiven Filter 28 und 29, die Ein- und Ausgangsregister der Quadrierer 30 und 31 und der Multiplizierer 34, 35, 38 und 39 sowie die Verzögerungsglieder 36 und 37 getaktet.

Die Analog-Digitalwandler 20 und 21 wandeln das anliegende frequenzmodulierte Signal in ein digitales Wort um, wobei der Analog-Digitalwandler 21 die Abtastung um T/4 versetzt vornimmt. Die an den Ausgängen der Analog-Digitalwandler 20 und 21 anliegende Signale sind zwar an und für sich zueinander Hilbert-transformiert, weisen jedoch einen Zeitversatz auf. Dieser Fehler kann durch eine lineare Interpolation des Ausgangssignals des Analog-Digitalwandlers 20 und durch eine entsprechende Rückrechnung ausgeglichen werden. Dies erfolgt dadurch, daß der erste Vergangenheitswert multipliziert mit 1/4 auf den aktuellen Wert multipliziert mit 3/4 addiert wird. Die Multiplikationen werden durch verdrahteten Shift und Addition ausgeführt. Der Faktor 3 wird im Addierer 25 erzeugt, indem das aktuelle Signal zunächst durch 1 Bit-Linksshift in 24 mit 2 multipliziert und dann im Addierer 25 zu sich selbst addiert wird. Das Vergangenheitssignal liegt am Ausgang des Verzögerungsgliedes 23 an. Der Ausgang von 25 und der Vergangenheitswert werden im Addierer 26 summiert, anschließend wird das Ergebnis im Shifter 27 durch 2 Bit-Rechtsshift mit 1/4 multipliziert. Das Ausgangssignal nach dem Shifter 27 ist nunmehr bis auf geringe Vernachlässigungen zu dem Ausgangssignal des Analog-Digitalwandlers 21 Hilbert-transformiert. Die Wirkung der nichtrekursiven Filter 28 und 29 ist zuvor bereits ausführlich erörtert worden.

Bereits zu einem früheren Zeitpunkt wurde erwähnt, daß eine Amplitudenkorrektur für schnelle Amplitudenstörungen wünschenswert wäre. Hierzu werden die beiden Ausgangssignale der nicht rekursiven Filter 28 und 29 in den Multiplizierer 30 und 31 quadriert und die Ergebnisse im Addierer 32 summiert. Das Resultat ergibt das Quadrat der Momentanamplitude. Möchte man ein auf eins normiertes Signal erhalten, so müssen die Ausgangssignale der Filter mit dem Kehrwert der Amplitude multipliziert werden. Dazu wird im PROM 33 die Funktion $1/\sqrt{x}$ abgespeichert, wobei x der Eingangswert des PROM's ist, in diesem Falle also die quadrierte Amplitude. Mit dem Ausgangswert des PROM's 33, also dem Kehrwert der Amplitude, werden in den Multiplizierern 34 und 35 die Filter-Ausgangswerte multipliziert. Man erhält so ein auf eins normiertes Hilbert-transformiertes Signalpaar. Um ein eindeutiges Nutzsignal zu erhalten, wird im Multiplizierer 38 bzw. im Multiplizierer 39 der erste Vergangenheitswert mit dem Hilbert-transformierten Wert multipliziert und das Ergebnis der Multiplizierer 38 und 39 im Addierer 40

8

aufaddiert. Ein Vergleich mit der Arcus-Sinustafel, die im Prom 41 abgelegt ist, ergibt das digitale demodulierte Nutzsignal. Zu einer Weiterverarbeitung kann zur Begrenzung von Rauschen ein geeignetes Tiefpaßfilter nachgeschaltet werden und nach einem Digital-Analogwandler das analoge Signal einem Verstärker zugeführt werden. Jedoch ist auch eine digitale Aufzeichnung oder Weiterverarbeitung, z. B. digitale Stereo-Decodierung des aufgenommenen Signals möglich. Die Weiterverarbeitung erfolgt ähnlich, wie dies bereits bei der digitalen Schallplatte der Fall ist.

Als Abtastfrequenz für die Analog-Digitalumwandler eignet sich eine Frequenz von 2,14 MHz bei der Demodulation eines ZF-Signals bei UKW-Rundfunkempfang. Die Weiterverarbeitung des Signals nach den nichtrekursiven Filtern 28 und 29 erfolgt mit 535 KHz. Die Quadrierer 30 und 31, die Multiplizierer 34 und 35, 38 und 39 sowie die Addierer 32 und 40 können beispielsweise durch einen handelsüblichen Multipliziererakkumulator realisiert sein, wie er beispielsweise unter der Bezeichnung TDC 1010 J von der Firma TRW angeboten wird. Zusätzlich wären dann allerdings Zwischenspeicher erforderlich.

Eine Schaltungsanordnung zur Erzeugung eines um T/4 verschobenen Taktsignals ist der Figur 10 zu entnehmen. Der Ausgang des Taktgenerators 42 führt zu dem Eingang eines 2-bit-Dualzählers 46 sowie zu jeweils einem Eingang eines UND-Gliedes 49 und 50. Der erste Ausgang des Dualzählers führt zu jeweils einem Eingang eines ODER-Gliedes 47 und eines UND-Gliedes 48. Der zweite Ausgang des Dualzählers führt zu einem weiteren Eingang des NOR-Gliedes 47. Der invertierte Ausgang des Dualzählers 46 führt zu einem weiteren Eingang des UND-Gliedes 48. Der Ausgang des NOR-Gliedes 47 führt zu dem zweiten Eingang des UND-Gliedes 49 der Ausgang des UND-Gliedes 48 zum zweiten Eingang des UND-Gliedes 50. An den Ausgang des UND-Gliedes 49 ist der Takteingang des Analog-Digitalwandlers 21, an den Ausgang des UND-Gliedes der Takteingang des A/D-Wandlers 20 angeschlossen. Die Wirkungsweise der Schaltungsanordnung nach Figur 10 ist anhand eines Diagramms in Figur 11 näher erläutert. Das Taktsignal des Taktgenerators 42 am Eingang des Teilers ist in Figur 11a dargestellt. Durch den Dualzähler mit den logischen Gattern liegt am Ausgang des UND-Gliedes 49 ein Signal nach Figur 11b, am Ausgang des UND-Gliedes 50 ein Signal nach Figur 11c an. Die Impulse nach Figur 11b und Figur 11c sind um T/4 verschoben. Ein Impuls wird nach jedem vierten Taktimpuls des Taktgenerator 42 abgegeben. Um eine Taktfrequenz von 2,14 MHz zu erreichen, ist es erforderlich, den Taktgenerator mit einer Frequenz von 8,56 MHz zu betreiben.

Figur 12 zeigt ein nichtrekursives Filter, wie es beispielsweise bei den beschriebenen Blockschaltbildern Verwendung findet. Das Eingangssignal gelangt zu einem vierstufigen Schieberegister 105, wobei jeder Schieberegisterplatz mit einem RAM 106 in Verbindung steht. Das Schieberegister wird durch einen Eingangstakt TE getaktet. Das RAM 106 weist zwei Ausgänge auf, die zu einem Addierer 109 geführt sind. Der Ausgang des Addierers 109 führt zu einem Eingang eines Multiplizierers 110. Der Ausgang eines weiteren RAM's 108 steht mit einem weiteren Eingang des Multiplizierers 110 in Verbindung. Die RAM 106 und 108 werden durch ein PROM 107 gesteuert. Der Ausgang des Multiplizierers 110 führt zu einem Summierer 111, der als Akkumulator geschaltet ist, der Ausgang des Summierers 111 führt zu einem Ausgangsschalters 112, an dessen Ausgang das Ausgangssignal abgreifbar ist. Der Ausgangsschalter 112 wird mit einem Takt TA getaktet.

Digitale nichtrekursive Filter sind im wesentlichen dadurch gekennzeichnet, daß die aktuellen Werte sowie Vergangenheitswerte mit vorgegebenen Koeffizienten multipliziert werden, wobei der Wert der Koeffizienten durch das gewünschte Verhalten des Filters bestimmt ist. Diese multiplizierten Werte werden addiert und stehen am Ausgang des Filters zur Verfügung. Nichtrekursive Filter sind linearphasig ausführbar, was sich dahingehend auswirkt, daß die Koeffizienten spiegelsymmetrisch zueinander gleich sind. Dies bietet den Vorteil, daß sich die Anzahl der zeitaufwendigen Multiplikationen halbieren läßt. Für ein Filter 18. Grades sind beispielsweise an und für sich neunzehn Multiplikationen erforderlich. Bei linearphasigen Filtern reduziert sich die Anzahl der Multiplikationen auf zehn. Hierfür müssen jedoch die abgespeicherten Zustandsvariablen vorab paarweise addiert werden. In dem in Figur 12 dargestellten nichtrekursiven Filter ergibt sich noch die Besonderheit der Abtastreduktion. Mit jedem Taktimpuls des Taktes TE wird der am Eingang des Schieberegisters 105 anliegende Wert in das Schieberegister übernommen und der Vergangenheitswert um eins weitergeschoben. Sind vier Werte eingelesen, so wird der gesamte Inhalt des Schieberegisters 105 in das RAM 106 übernommen und die vier Speicherwerte an vier bestimmten Speicherplätzen des RAM's 106 abgelegt. Danach werden vier weitere Werte in das Schieberregister 105 eingelesen und diese ebenfalls auf anderen Speicherplätzen des RAM 106 abgelegt. Die bereits vorher eingelesenen, entsprechend der Anzahl der Koeffizienten im RAM 106 abgespeicherten Werte werden durch die im ROM 107 abgelegte Steuerung aufgerufen, so daß jeweils der erste und der letzte, der zweite und der vorletzte usw. Wert an die Ausgänge des RAM's 106 gebracht wird und im Addierer 109 addiert werden. Gleichzeitig wird durch das PROM 107 im RAM 108 der entsprechende Koeffizient aufgerufen, mit der erste und der letzte Wert im Multiplizierer 110 multipliziert werden muß und mit denen der vorletzte und der zweite Wert multipliziert werden muß. Die Ergebnisse des Multiplizierers 110 werden im Akkumulator 111 aufsummiert. Durch die vorherige Addition zweier Zustandsvariablen im Addierer 109 wird die Anzahl der Multiplikationen im Multiplizierer 110 reduziert. Sollen die Koeffizienten des Filters nicht verändert werden, können diese auch im PROM 107 abgespeichert sein. Ist jedoch eine Veränderung der Koeffizienten und damit der Filtereigenschaften beispielsweise in Abhängigkeit vom empfangenen Signal vorgesehen, so ist es zweckmäßig, die Koeffizienten in einem RAM abzulegen, da sie dort geändert werden können. Der Summenwert wird in das Ausgaberegister 112 eingelesen, wo es während einer Abtasttakt-Periode zur Weiterverarbeitung zur Verfügung steht. Die Addition zweiter Zustandsvariablen und die Multiplikation mit den Koeffizienten wird jedesmal durchgeführt, sobald durch das Schieberegister 105 neue Werte in RAM 106 übernommen werden, so daß nach jeder Übernahme ein neuer Ausgangswert bestimmt werden kann. Die Abtastreduktion ergibt sich dadurch, daß nur nach jedem vierten Wert am Eingang des Schieberegisters 105 eine Übernahme der gesamten im Schieberegister 105 eingelesenen Werte erfolgt. Der Faktor der Abtastreduktion bestimmt daher die Länge des Schieberregisters 105. Die Anforderungen an die Multiplizierer und Addierer sind recht hoch. Bei einem Filter 18. Grades sind pro Takteinheit zehn Multiplikationen und Additionen durchzuführen. Bei einem Filter vom Grad 38 sind zwanzig Multiplikationen und Additionen pro Takteinheit durchzuführen. Zu beachten ist außerdem, daß das Schieberegister 105 und die RAMs 106 und 108, und die Rechenbausteine 109 bis 111 entsprechend der Breite des Datenwortes, beispielsweise für acht Bit am Eingang und 16 Bit am Ausgang ausgelegt sein müssen. Je nach der erforderlichen Genauigkeit kann sich die Zahl der Bits je Wort erhöhen, da bei der Multiplikation mit höheren Dualzahlen zu rechnen ist.

Zur Realisierung eines Demodulators beispielsweise nach Figur 2 sind neben einer Arcus-Sinus-Umsetzung zwei Multiplikationen, eine Addition sowie zwei Register als Verzögerungsglieder erforderlich. Weiterhin kommen einige Operationen für die erläuterte Amplitudenregelung : zwei Quadraturen, eine Addition, eine Tafel zur Bildung von $1/\sqrt{x}$ und schließlich zwei weitere Multiplikationen zur Korrektur der AM-gestörten Signale. Eine Reihe der notwendigen arithmetischen Operationen werden vorteilhafterweise mit einem Multiplizierer-Akkumulator durchgeführt, wie er in der Litarturstelle « Multiplier-Accumulators, TRW-LSI products, TRW Inc. 1979 » beschrieben ist. Demgemäß ist in Figur 13 ein Rechenwerk konzipiert, daß im Kern einen 16-bit-Multiplizierer-Akkumulator (MAC) 120 enthält. Die intern vorhandenen Register dieses Bausteins reichen für alle erforderlichen Zwischenspeicherfunktionen nicht aus, so daß weitere externe Register erforderlich sind. Schließlich kommen zwei PROM-Bausteine für die Berechnung der Momentanamplituden und die Arcus-Sinus-Umsetzung hinzu.

Am Eingang der Schaltungsanordnung stehen die beiden Register 115 und 116, an denen die Filterausgangssignale, beispielsweise der Filter 28 und 29 in Figur 9, zur Verfügung stehen. Die Ausgänge der Register 115 und 116 führen zu einer Datenbusleitung 117. An die Datenbusleitung 117 sind die Register 118, 126, 127 und 123 angeschlossen. Die Ausgänge der Register 118 und 126 führen zur Busleitung 119. Der Ausgang des Registers 127 steht mit dem PROM 128 zu Wurzelbildung in Verbindung. Der Ausgang des Registers 123 ist an den Datenbus 129 gelegt. Der Multiplizierer-Akkumulator 120 hat zwei Eingangsregister 121 und 122, wobei das eine Register mit dem Bus 119, das zweite Register mit dem Bus 129 verbunden ist. Die Ausgänge der beiden Register führen zu einem Multiplizierer 124. Das Ausgangssignal des Multiplizierers 124 führt zu einem Akkumulatorspeicher 125. Der Ausgang des Multiplizierer-Akkumulators führt wiederum zum Datenbus 1 an den weiterhin ein Ausgaberegister 132 angeschlossen ist. Dem Ausgaberegister 132 folgt ein PROM 133 mit einer Arcus-Sinus-Tafel. Dem PROM 133 folgt ein Ausgaberegister 134, an dem das digitale demodulierte Signal abgreifbar ist. Über einem Analog-Digital-Wandler 135 ist auch das analoge Ausgangssignal abgreifbar.

Die Registerwerte in den Eingangsregistern 115 und 116 werden zur Amplitudenkorrektur zunächst quadriert, indem der Inhalt des Registers 115 über das Register 118 in das Eingaberegister 121 des MAC sowie über das Register 123 in das Eingaberegister 122 des MAC gelangt. Nach der Multiplikation im Multiplizierer 124 geschieht das Entsprechende für das Signal des Registers 116. Nach einem Akkumulationsschritt steht die Quadratsumme in Akkumulationsregister 125, von wo es über das Register 127 zum PROM 128 gelangt, in dem die Wurzel des Ausdrucks gebildet wird. Der so berechnete Amplitudenkorrekturfaktor gelangt über den Datenbus 129 in das Register 122 des MAC. Die Eingangswerte in dem Register 115 und 116 werden nun über das Register 18 der Reihe nach in den Eingangsspeicher des MAC 121 geladen, multipliziert und somit auf eins normiert. Die normierten Signale im Akkumulatorregister 125 werden der Reihe nach in die Register 118 und 126 geladen. Die Amplitudenregelung ist damit abgeschlossen und es folgt die eigentliche Demodulation.

Dazu werden die in den Registern 130 und 131 im vorherigen Rechenzyklus abgespeicherten Signalwerte mit den aktuellen Werten in den Registern 118 und 126 entsprechend multipliziert und die beiden Produkte im Akkumulator subtrahiert. Das Ergebnis erscheint über das Register 132 an der Adresse des PROM's 133 das die Arcus-Sinus-Entzerrung vornimmt. Die Arcus-Sinus-Tafel ist so ausgelegt, daß sich bei einem Hub von 100 KHz die Maximalaussteuerung, also die Amplitude 1, am Ausgang ergibt. Damit ist der Demodulationszyklus abgeschlossen. Das gewonnene FM-Signal kann digital weiterverarbeitet oder auch analog über den Analog-Digital-Wandler 135 ausgegeben werden. Bevor ein neuer Zyklus beginnt, werden die Inhalte der Speicher 118 und 126 den Registern 130 und 131 übergeben.

Insgesamt erfordert der hier geschilderte Ablauf 16 Taktzyklen. Unter Zuhilfenahme des obigen Beispiels steht bei einer Gesamtzeit von 1,87 µs also für jede Elementaroperation 116 ns zur Verfügung. Da die typische Multiplikationszeit der augenblicklich verwendbaren Multiplizierer-Akkumulatoren bei 150 ns liegen, muß darauf geachtet werden, daß für die sechs Multiplikationsvorgänge jeweils zwei Elementarzyklen zur Verfügung stehen.

Die Steuerung des Rechenablaufs erfolgt durch ein nicht dargestelltes Steuer-PROM, das durch einen 4-bit-Zähler mit einer Taktfrequenz von 8.65 MHz adressiert wird. Die Steuersignale werden über ein nicht dargestelltes Pipeline-Register an das Rechenwerk übergeben.

Die gesamten Demodulatoren sind vorteilhafterweise integriert herstellbar. Sämtliche Speichereinheiten und Rechenwerke können auf einem Chip untergebracht werden. Da die Eigenschaften des Demodulators im wesentlichen durch die Filtereigenschaften bestimmt sind, kann durch einfache Änderung der Koeffizienten im RAM 108 bzw. im ROM 107 die Eigenschaft des Demodulators geändert werden, um sie verschiedenen Anwendungen anzupassen. Die Abtastfrequenzen richten sich ebenfalls nach dem Anwendungsfall. Sie können bei einer geänderten Trägerfrequenz bzw. bei einer anderen Bandbreite des analogen Vorfilters entsprechend gewählt werden. Die Genauigkeit des Demodulators ist im wesentlichen abhängig von der Bitzahl des Wortes und der Bitzahl seiner Weiterverarbeitung. Die Genauigkeit der Auflösung kann dadurch beliebig verändert werden.

**Patentansprüche**

1. Demodulator für frequenzmodulierte Signale in digitaler Form, bei dem das Signal zwei getrennten Zweigen zugeführt wird, die jeweils zumindest ein nichtrekursives Filter (3, 4, 58, 59) aufweisen, wobei die Abtastrate am Ausgang der nichtrekursiven Filter (3, 4, 58, 59) geringer ist als die Abtastrate vor den Filtern (3, 4, 58, 59), dadurch gekennzeichnet, daß die Ausgangssignale der nichtrekursiven Filter (3, 4, 58, 59) zumindest näherungsweise zueinander Hilbert-transformiert sind und jeweils einem Verzögerungsglied (7, 8, 60, 61) zugeführt sind, daß das verzögerte Signal mit dem Hilbert-transformierten Signal des jweils anderen Zweiges multipliziert ist und daß die Differenz der beiden multiplizierten Signale gebildet ist.

2. Demodulator nach Anspruch 1, dadurch gekennzeichnet, daß dem Differenzbilder (11) ein Arcus-Sinus-Wandler (12) nachgeschaltet ist.

3. Demodulator nach Anspruch 1 oder 2, dadurch gekennzeichnet, daß die Abtastung für beide Filter (3, 4) versetzt erfolgt und daß dadurch sowie durch nachfolgende Interpolation die näherungsweise Hilbert-Transformation erfolgt.

4. Demodulator nach Anspruch 3, dadurch gekennzeichnet, daß die Interpolation durch Shiftung (24, 27) und Mittelwertbildung mit dem ersten Vergangheitswert erfolgt.

5. Demodulator nach einem der Ansprüche 1 bis 4, dadurch gekennzeichnet, daß nach den nichtrekursiven Filtern (28, 29) eine Amplitudenregelung vorgesehen ist.

6. Demodulator nach Anspruch 5, dadurch gekennzeichnet, daß die Ausgangssignale der nichtrekursiven Filter (28, 29) quadriert und addiert und daß diese Signale oder eine Funktion davon zur Normierung mit den Ausgangssignalen der nichtrekursiven Filter (28, 29) multipliziert ist.

7. Demodulator nach Anspruch 1, dadurch gekennzeichnet, daß vor den ersten nichtrekursiven Filtern (58, 59) das Signal in digitaler Form in einem Zweig mit einer Sinusfunktion und im anderen Zweig mit einer Kosinusfunktion multipliziert ist.

8. Demodulator nach Anspruch 7, dadurch gekennzeichnet, daß dem Differenzbilder (64) ein Arcus-Sinus-Wandler (65) nachgeschaltet ist.

9. Demodulator nach Anspruch 7 oder 8, dadurch gekennzeichnet, daß jeweils ein weiteres digitales nichtrekursives Filter vorgesehen ist.

10. Demodulator nach einem der Ansprüche 7 bis 9, dadurch gekennzeichnet, daß die Abtastung der Multiplizierer (56, 57, 71, 72) jeweils zu den Nulldurchgängen und den Extremwerten der Sinus- bzw. Cosinusfunktion erfolgt.

11. Demodulator nach Anspruch 10, dadurch gekennzeichnet, daß die Sinus-Cosinus-Multiplikation über einen Festwertspeicher (89, 90) erfolgen.

12. Demodulator nach einem der Ansprüche 1 bis 11, dadurch gekennzeichnet, daß die Abtastung am Ausgang der nichtrekursiven Filter niedriger ist als die Signalfolge am Eingang der Filter.

13. Demodulator nach einem der Ansprüche 1 bis 12, dadurch gekennzeichnet, daß die nichtrekursiven Filter mit einem Schieberegister (105) aufgebaut sind, deren Signalfolge in einem Speicher (106) als Zustandsvariable abgespeichert sind und daß die Zusandsvariablen mit den die Eigenschaften des Filters bestimmenden Koeffizienten, die in einem weiteren Speicher (108) abgelegt sind, multipliziert sind und daß das Ergebnis in einem Akkumulator (111) aufsummiert ist.

14. Demodulator nach Anspruch 13, dadurch gekennzeichnet, daß die Zustandsvariablen, die mit gleichen Koeffizienten zu multiplizieren sind, gemeinsam abgerufen, addiert, dann multipliziert werden.

15. Demodulator nach Anspruch 13 oder 14, dadurch gekennzeichnet, daß das Schieberegister (105) zumindest eine der Abtastreduktion entsprechende Anzahl von Plätzen aufweist.

16. Demodulator nach einem der Ansprüche 13 bis 15, dadurch gekennzeichnet, daß die die Eigenschaften des Filters bestimmenden Koeffizienten insbesondere in Abhängigkeit der Empfängsstärke oder manuell veränderbar sind.

17. Demodulator nach einem der Ansprüche 1 bis 16, dadurch gekennzeichnet, daß dem Demodulator ein Entzerrungsfilter mit leicht ansteigendem Verlauf nachgeschaltet ist, das oberhalb der Grenzfrequenz des übertragenden Signals abfällt.

18. Demodulator nach einem der Ansprüche 1 bis 17, dadurch gekennzeichnet, daß am Eingang des Demodulators ein Analog-Digitalwandler (50, 70) bzw. für jeden Zweig je ein Analog-Digitalwandler (1, 2, 20, 21) vorgeschaltet ist.

19. Demodulator nach Anspruch 18, dadurch gekennzeichnet, daß den Analog-Digitalwandlern ein Bandpaß vorgeschaltet ist.

## Claims

1. Demodulator for frequency-modulated signals in digital form, wherein the signal is fed to two separate branches, each of which exhibits at least one non-recursive filter (3, 4, 58, 59), the scanning rate at the output of the non-recursive filters (3, 4, 58, 59) being less than the scanning rate in front of the filters (3, 4, 58, 59), characterized in that the output signals of the non-recursive filters (3, 4, 58, 59) are at least approximately Hilbert-transformed relative to one another and are paired in each instance to a delay element (7, 8, 60, 61), in that the delayed signal is multiplied by the Hilbert-transformed signal of the respective other branch, and in that the difference of the two multiplied signals is formed.

2. Demodulator according to Claim 1, characterized in that an inverse sine convertor (12) is connected behind the difference former (11).

3. Demodulator according to Claim 1 or Claim 2, characterized in that the scanning for both filters (3, 4) takes place with a displacement, and in that the approximate Hilbert-transformation is carried out thereby as well as by subsequent interpolation.

4. Demodulator according to Claim 3, characterized in that the interpolation takes place by shifting (24, 27) and mean value formation together with the first past value.

5. Demodulator according to one of Claims 1 to 4, characterized in that an amplitude control circuit is provided behind the non-recursive filters (28, 29).

6. Demodulator according to Claim 5, characterized in that the output signals of the non-recursive filters (28, 29) are squared and added, and in that these signals or a function thereof is multiplied for standardization by the output signals of the non-recursive filters (28, 29).

7. Demodulator according to Claim 1, characterized in that in front of the first non-recursive filters (58, 59) the signal, in digital form, is multiplied, in one branch, by a sine function and, in the other branch, by a cosine function.

8. Demodulator according to Claim 7, characterized in that an inverse sine convertor (65) is connected behind the difference former (64).

9. Demodulator according to Claims 7 or 8, characterized in that a respective further digital non-recursive filter is provided.

10. Demodulator according to one of Claims 7 to 9, characterized in that the scanning of the multipliers (56, 57, 71, 72) takes place in each instance at the null passages and the extreme values of the sine and cosine function respectively.

11. Demodulator according to Claim 10, characterized in that the sine-cosine multiplication takes place by means of a read-only memory (86, 90).

12. Demodulator according to one of Claims 1 to 11, characterized in that the scanning at the output of the non-recursive filters is smaller than the signal sequence at the input of the filters.

13. Demodulator according to one of Claims 1 to 12, characterized in that the non-recursive filters are constructed with a shift register (105), the signal sequences of which are stored in a memory (106) as parameters of state, and in that the parameters of state are multiplied by the coefficients which determine the properties of the filter and which are stored in a further memory (108), and in that the result is summed in an accumulator (111).

14. Demodulator according to Claim 13, characterized in that the parameters of state which are to be multiplied by equal coefficients are called up together added and then multiplied.

15. Demodulator according to Claim 13 or 14, characterized in that the shift register (105) exhibits at least a number of places corresponding to the scanning reduction.

16. Demodulator according to one of Claims 13 to 15, characterized in that the coefficients determining the properties of the filter are variable in particular as a function of the reception intensity or manually.

17. Demodulator according to one of Claims 1 to 16, characterized in that an equalizing filter with a slightly rising characteristic is connected behind the demodulator, which filter declines above the limiting frequency of the carrying signal.

. 18. Demodulator according to one of Claims 1 to 17, characterized in that an analogue-digital converter (50, 70) or for each branch a respective analogue-digital converter (1, 2, 20, 21) is connected in front at the input of the demodulator.

19. Demodulator according to Claim 18, characterized in that a band-pass filter is connected in front of the analogue-digital converters.

## Revendications

1. Démodulateur pour des signaux modulés en fréquence sous forme numérique, démodulateur dans lequel le signal est appliqué à deux branchements de dérivation séparés, qui comportent chacun au moins un filtre non récursif (3, 4, 58, 59), la vitesse de balayage à la sortie du filtre non récursif (3, 4, 58, 59) étant moindre que la vitesse de balayage en avant de ce filtre (3, 4, 58, 59), démodulateur caractérisé en ce que les signaux de sortie du filtre non récursif (3, 4, 58, 59) subissent au moins approximativement les uns par rapport aux autres, une transformation de Hilbert et sont respectivement appliqués à un organe de temporisation (7, 8, 60, 61), le signal ainsi temporisé étant multiplié par le signal, ayant subi la transformation de Hilbert, de l'autre branchement de dérivation, et la différence des deux signaux ainsi multipliés étant formée.

2. Démodulateur selon la revendication 1, caractérisé en ce qu'un convertisseur arc-sinus (12) est branché à la suite du dispositif (11) de formation de la différence.

3. Démodulateur selon la revendication 1 ou 2, caractérisé en ce que le balayage pour deux filtres (3, 4) est décalé, et que de ce fait, ainsi que du fait de l'interpolation qui y fait suite, la transformation approximative de Hilbert est effectuée.

4. Démodulateur selon la revendication 3, caractérisé en ce que l'interpolation s'effectue avec la première valeur précédente par décalage (24, 27) et formation de la valeur moyenne.

5. Démodulateur selon une des revendications 1 à 4, caractérisé en ce qu'il est prévu, après les filtres non récursifs, une régulation d'amplitude.

6. Démodulateur selon la revendication 5, caractérisé en ce que les signaux de sortie des filtres non récursifs (28, 29) sont élevés au carré et totalisés, et que ces signaux ou une fonction de ces signaux, sont multipliés pour les normaliser avec les signaux de sortie des filtres non récursifs (28, 29).

7. Démodulateur selon la revendication 1, caractérisé en ce que, en avant des premiers filtres non récursifs (58, 59), le signal sous forme numérique est multiplié dans un branchement de dérivation avec une fonction sinus et dans l'autre branchement de dérivation avec une fonction cosinus.

8. Démodulateur selon la revendication 7, caractérisé en ce qu'un convertisseur arc-sinus (65) est branché à la suite du dispositif (64) de formation de la différence.

9. Démodulateur selon la revendication 7 ou 8, caractérisé en ce qu'il est respectivement prévu un autre filtre numérique non récursif.

10. Démodulateur selon une des revendications 7 à 9, caractérisé en ce que le balayage des multiplicateurs (56, 57, 71, 72) s'effectue respectivement aux passages par zéro et aux valeurs extrêmes de la fonction sinus ou bien de la fonction cosinus.

11. Démodulateur selon la revendication 10, caractérisé en ce que les multiplications sinus-cosinus s'effectuent par l'intermédiaire d'une mémoire à valeur fixe (89, 90).

12. Démodulateur selon une des revendications 1 à 11, caractérisé en ce que le balayage à la sortie des filtres non-récursifs est plus lent que la succession des signaux à l'entrée des filtres.

13. Démodulateur selon une des revendications 1 à 12, caractérisé en ce que les filtres non récursifs sont constitués par un registre à décalage (105), dont les successions de signaux sont déposées, en tant que variables d'état, dans une mémoire (106), et ces variables d'état sont multipliées par les coefficients, déterminant les caractéristiques du filtre, qui sont déposés dans une autre mémoire (108), le résultat étant totalisé dans un accumulateur (111).

14. Démodulateur selon la revendication 13, caractérisé en ce que les variables d'état qui doivent être multipliées par les mêmes coefficients, sont appelées, totalisées, puis multipliées en commun.

15. Démodulateur selon la revendication 13 ou 14, caractérisé en ce que le registre à décalage (105) comporte au moins un nombre de places correspondant à la réduction de balayage.

16. Démodulateur selon une des revendications 13 à 15, caractérisé en ce que les coefficients déterminant les caractéristiques du filtre sont susceptibles d'être modifiés notamment en fonction de l'intensité de réception, ou bien manuellement.

17. Démodulateur selon une des revendications 1 à 16, caractérisé en ce qu'un filtre de correction, avec une allure légèrement ascendante, qui tombe au-dessus de la fréquence limite du signal à transmettre, est branché à la suite du démodulateur.

18. Démodulateur selon une des revendications 1 à 17, caractérisé en ce qu'à l'entrée du démodulateur, est branché un convertisseur analogique-numérique en amont (50, 70), ou bien pour chaque branchement de dérivation respectivement un convertisseur analogique-numérique (1, 2, 20, 21).

19. Démodulateur selon la revendication 18, caractérisé en ce qu'un filtre passe-bande est branché en amont des convertisseurs analogiques-numériques.

$\cos\left(2\pi\,\dfrac{f_0}{f_A}\cdot k\right)$

$\sin\left(2\pi\,\dfrac{f_0}{f_A}\cdot k\right)$

Fig. 1

0 080 014

Fig. 2

a)

2 MHz

2,14          8,56          f (MHz)

b)

TP 73,74

2,14    4,28          8,56          f (MHz)

c)

TP 77,78

0,535    1,07          2,14          f (MHz)

Fig.3

0.40

0.20

0.00

-0.20

-0.40

409.80    819.20    1228.80

Fig.6a

3

Fig. 4

4

Fig. 5

Fig. 6 b

Fig. 6 c

Fig. 7

Fig. 8

0 080 014

Fig.9

0 080 014

Fig. 10

Fig. 11

Fig.12

E

TE

105

106 RAM

107 PROM

RAM 108

109 +

110 ×

111 Σ

TA

T 112

0 080 014

Fig. 13

0 080 014